# EUROPÄISCHE PATENTSCHRIFT

(11) **EP 4 424 114 B1**
(45) Veröffentlichungstag und Bekanntmachung des Hinweises auf die Patenterteilung: **24.09.2025**
(21) Anmeldenummer: 21799254.4
(22) Anmeldetag: 25.10.2021
(51) Int. Cl.: H05G 2/00, G02B 26/08

(54) **EUV-LICHTQUELLE MIT EINER STRAHLLAGESTELLEINRICHTUNG**
EUV LIGHT SOURCE WITH A BEAM POSITIONING DEVICE
SOURCE LUMINEUSE EUV AVEC UN DISPOSITIF DE POSITIONNEMENT DU FAISCEAU

(43) Veröffentlichungstag der Anmeldung: 04.09.2024
(73) Patentinhaber: TRUMPF Lasersystems for Semiconductor Manufacturing SE, 71254 Ditzingen (DE)
(72) Erfinder: LAMBERT, Martin, 71404 Korb (DE); REGAARD, Boris, 70499 Stuttgart (DE); ERGIN, Tolga, 74321 Bietigheim-Bissingen (DE); SCHLOSSER, Oliver, 70794 Filderstadt (DE)
(74) Vertreter: Trumpf Patentabteilung
(86) Internationale Anmeldenummer: PCT/EP2021/079514
(87) Internationale Veröffentlichungsnummer: WO 2023/072362

(56) Entgegenhaltungen:
- WO-A1-2015/036025
- DE-A1- 102015 109 984
- US-A1- 2010 117 009

## Beschreibung

### Hintergrund der Erfindung

Die Erfindung betrifft eine EUV-Lichtquelle, umfassend eine Bereitstellungseinrichtung zur Bereitstellung eines Targetmaterials, mindestens eine gepulste Laserquelle zur Emission mindestens eines gepulsten Laserstrahls, eine Strahlführungseinrichtung zur Zuführung des mindestens einen gepulsten Laserstrahls von der mindestens einen gepulsten Laserquelle in eine Strahlungserzeugungskammer und zur fokussierten Bestrahlung des Targetmaterials mit dem mindestens einen gepulsten Laserstrahl innerhalb der Strahlungserzeugungskammer, wobei das Targetmaterial ausgebildet ist, in Folge der Bestrahlung EUV-Strahlung zu emittieren.

Eine EUV-Lichtquelle ist eine Strahlungsquelle, die zur Emission von EUV-Strahlung dient. EUV-Strahlung bezeichnet elektromagnetische Strahlung mit einer Wellenlänge zwischen ca. 5 nm und ca. 30 nm. EUV-Strahlung findet insbesondere in der Halbleiterindustrie Anwendung. Verglichen mit derzeit verbreiteten Lithographieanlagen, die mit Wellenlängen im UV-Wellenlängenbereich betrieben werden, erlaubt der Einsatz von EUV-Strahlung für die mikrolithographische Fertigung die zuverlässige Herstellung von Komponenten mit wesentlich kleineren Strukturgrößen und führt damit zu einer entsprechenden Leistungssteigerung.

Die eingangs genannte EUV-Lichtquelle eignet sich für die Erzeugung von EUV-Strahlung mittels eines LPP ("Laser Produced Plasma") Prozesses. Das Targetmaterial, bei dem es sich typischerweise um ein Metall, insbesondere um Zinn handelt, wird mittels der Bereitstellungseinrichtung bevorzugt in Tröpfchenform bereitgestellt. Ein jeweiliges Tröpfchen wird dann innerhalb der Strahlungserzeugungskammer, beispielsweise einer Vakuumkammer, mit einem oder mehreren Laserpulsen des mindestens einen Laserstrahls bestrahlt. Im Fall mehrerer Laserpulse umfassen diese beispielsweise einen, zwei oder ggf. mehr als zwei sogenannte Vorpulse und einen sogenannten Hauptpuls. Der Vorpuls beziehungsweise die Vorpulse dienen dazu, das Tröpfchen für die Bestrahlung mit dem Hauptpuls vorzubereiten, insbesondere das Tröpfchen aufzuheizen, zu expandieren, zu vaporisieren und/oder ein Plasma zu erzeugen. Die anschließende Bestrahlung eines jeweiligen Tröpfchens mit jeweils einem Hauptpuls dient dazu, das Targetmaterial in den Plasmazustand zu überführen, wodurch es zur Emission von EUV-Strahlung kommt.

Entsprechend kann es sich bei dem mindestens einen gepulsten Laserstrahl beispielsweise um mindestens einen Vorpulslaserstrahl bzw. einen Hauptpulslaserstrahl handeln. Bei der mindestens einen gepulsten Laserquelle handelt es sich dann beispielsweise um mindestens eine Vorpulslaserquelle bzw. eine Hauptpulslaserquelle. Als Vorpulslaserquelle kann zum Beispiel ein CO2-Laser, als Hautpulslaserquelle zum Beispiel ein Festkörperlaser zum Einsatz kommen.

Die Strahlführungseinrichtung dient dazu, den mindestens einen gepulsten Laserstrahl von der mindestens einen gepulsten Laserquelle in die Strahlungserzeugungskammer zuzuführen. Zu diesem Zweck umfasst die Strahlführungseinrichtung typischerweise eine Vielzahl optischer Elemente, insbesondere eine Vielzahl reflektiver optischer Elemente. Handelt es sich um mehrere gepulste Laserstrahlen, so können deren Strahlengänge getrennt voneinander verlaufen oder zumindest abschnittsweise zusammenfallen. Beim Einsatz mehrerer Vorpulslaserstrahlen können diese zumindest teilweise kollinear verlaufen; dies ist aber nicht zwingend der Fall. Zur fokussierten Bestrahlung des Targetmaterials umfasst die Strahlführungseinrichtung ferner mindestens ein optisches Element mit dem der mindestens eine gepulste Laserstrahl fokussiert wird.

Eine Strahlführungseinrichtung für eine EUV-Strahlungserzeugungsvorrichtung ist aus der WO 2015/036025 A1 bekannt geworden. Dort wird ein Paraboloid-Spiegel zur Überlagerung von zwei Laserstrahlen genutzt, die auf einen ersten und auf einen zweiten Flächenbereich des Paraboloid-Spiegels auftreffen. Im Strahlengang des zweiten Laserstrahls ist eine Teleskopanordnung mit zwei Linsen angeordnet, deren Abstand zur Veränderung einer Fokusposition des zweiten Laserstrahls in einer Richtung senkrecht zur Bewegungsrichtung des Targetmaterials einstellbar ist. Zur Veränderung der Fokusposition des zweiten Laserstrahls entlang der Bewegungsrichtung des Target-Materials können verkippbare Umlenkspiegel verwendet werden.

### Aufgabe der Erfindung

Aufgabe der Erfindung ist es, eine EUV-Lichtquelle der eingangs genannten Art bereitzustellen, die eine genaue Positionierung des mindestens einen fokussierten gepulsten Laserstrahls auf dem Targetmaterial und eine Einstellung des Auftreffwinkels erlaubt und sich dabei bevorzugt durch eine hohe Dynamik bei gleichzeitig hoher Stellauflösung auszeichnet.

### Gegenstand der Erfindung

Diese Aufgabe wird gelöst durch eine EUV-Lichtquelle der eingangs genannten Art, bei der die Strahlführungseinrichtung zur Einstellung der räumlichen Lage des mindestens einen gepulsten Laserstrahls mindestens eine Strahllagestelleinrichtung aufweist, die vier Spiegel in Form zweier Spiegelpaare umfasst, wobei die vier Spiegel um jeweils genau eine Drehachse drehbar sind und die Drehachsen der beiden Spiegel des ersten Spiegelpaars entlang einer ersten Raumrichtung und die Drehachsen der beiden Spiegel des zweiten Spiegelpaars entlang einer zweiten Raumrichtung ausgerichtet sind.

Unter der räumlichen Lage eines Laserstrahls wird im Sinne dieser Anmeldung die Kombination aus der Position und der Strahlrichtung des Laserstrahls verstanden. Geht man davon aus, dass der Laserstrahl eine vorgegebene Ebene schneidet, so kann die Position des Laserstrahls über den Schnittpunkt mit dieser Ebene beschrieben werden. Insgesamt ergeben sich damit für die räumliche Lage vier Freiheitsgrade: zwei Ortskoordinaten zur Beschreibung des Schnittpunkts des Laserstrahls mit der Ebene und zwei Winkel zur Beschreibung der Strahlrichtung.

Die vier Spiegel können so ausgebildet sein, dass eine vollständige Umdrehung oder nur eine Drehbarkeit in einem eingeschränkten Winkelbereich möglich ist. Für die Drehung der Spiegel kann beispielsweise für jeden Spiegel ein separater Antrieb vorgesehen sein. Unter einem Spiegelpaar wird im Sinne dieser Anmeldung eine Gesamtheit aus zwei Spiegeln verstanden.

Mittels der mindestens einen Strahllagestelleinrichtung lässt sich die räumliche Lage des mindestens einen gepulsten Laserstrahls gezielt einstellen. Damit kann das Targetmaterial, beispielsweise ein Zinntröpfchen, mit einer hohen Genauigkeit, typischerweise einer Genauigkeit von einem Mikrometer oder weniger, getroffen und gleichzeitig der Auftreffwinkel mit einer Genauigkeit in der Größenordnung von Mikroradiant eingestellt werden. Dies führt letztlich zu einer hohen Effizienz der EUV-Lichtquelle.

Wird das Targetmaterial mit mehreren gepulste Laserstrahlen bestrahlt, so kann die Strahlführungseinrichtung mehrere Strahllagestelleinrichtungen aufweisen. Jede der Strahllagestelleinrichtungen kann dabei zur Einstellung der räumlichen Lage jeweils eines der gepulsten Laserstrahlen dienen. Auch kann eine Strahllagestelleinrichtung zur Einstellung der räumlichen Lagen mehrerer der gepulsten Laserstrahlen dienen. Im letzteren Fall können die räumlichen Lagen allerdings nicht unabhängig voneinander eingestellt werden.

Über die gleichzeitige Verstellung von Position und Strahlrichtung kann ferner der Drehpunkt des Laserstrahls auf einen beliebigen Punkt in Propagationsrichtung des gepulsten Laserstrahls gelegt werden. In anderen Worten kann durch eine Verstellung der Spiegel der mindestens eine Laserstrahl um einen beliebigen Punkt (in Propagationsrichtung des gepulsten Laserstrahls) gedreht werden. Dies ist neben der Anwendung in EUV-Lichtquellen grundsätzlich auch für andere optische Aufbauten von großer Bedeutung, um beispielsweise eine gute Abbildungsqualität und kleinere Aperturen an den optischen Elementen zu gewährleisten.

Eine wichtige Kenngröße der Strahllagestelleinrichtung ist die damit erzielte Stellauflösung der räumlichen Lage des gepulsten Laserstrahls. Hier ist es zweckmäßig, die Stellauflösung für die Strahlrichtung und die Position des gepulsten Laserstrahls getrennt zu betrachten. Die Stellauflösung für die Strahlrichtung ist durch die Winkelauflösung, also die Auflösung der Drehung der Spiegel, vorgegeben und damit vom eingesetzten Antrieb abhängig. Die Stellauflösung für die Position des gepulsten Laserstrahls senkrecht zur ersten Raumrichtung ergibt sich aus der Winkelauflösung und dem Abstand zwischen den beiden Spiegeln des ersten Spiegelpaares. Die Stellauflösung für die Position des gepulsten Laserstrahls senkrecht zur zweiten Raumrichtung ergibt sich entsprechend aus der Winkelauflösung und dem Abstand zwischen den beiden Spiegeln des zweiten Spiegelpaares.

Gegenüber Vorrichtungen, welche zur Einstellung der Strahllage eines Laserstrahls zwei um zwei Achsen drehbare Spiegel aufweisen, die motorisch oder manuell verstellbar sind und aufgrund der zweiachsigen Bauweise nur langsame Justagevorgänge mit einer Grenzfrequenz im Bereich weniger Hertz erlauben, ermöglicht die Strahllagestelleinrichtung eine um Größenordnungen schnellere Justage und damit eine höhere Dynamik. Auch kann bei Spiegeln, die lediglich um eine Drehachse drehbar sind, typischerweise eine höhere Winkelauflösung erzielt werden, was in einer entsprechend höheren Stellauflösung der räumlichen Lage des gepulsten Laserstrahls resultiert.

Vorrichtungen, die eine Verstellung des Strahlwinkels eines Laserstrahls durch Spiegel erlauben, die um genau eine Drehachse drehbar sind, werden auch in der Lasermaterialbearbeitung, beispielsweise beim Laserbeschriften oder Remote-Laserschweißen, eingesetzt. Die Verkippung des Laserstrahls erfolgt dabei über eine Drehung der Spiegel, an welchen der - in der Regel kollimierte - Laserstrahl reflektiert wird, mittels eines geeigneten Antriebs. Zur Realisierung einer beliebigen Kippbewegung in zwei Achsen werden zwei dieser Spiegel hintereinander angeordnet. Die Fokussierung auf der typischerweise flachen Bearbeitungsebene wird über F-Theta-Linsen realisiert. Um einen konstanten Auftreffwinkel auf die Bearbeitungsebene zu erzielen, wird typischerweise eine telezentrische F-Theta-Linse eingesetzt. Derartige Vorrichtungen erlauben aber meist keine Einstellung der räumlichen Lage des Laserstrahls, sondern sind in der Regel auf zwei (Winkel-)Freiheitsgrade beschränkt.

Eine Ausnahme ist die DE 10 2015 109 984 A1, in der ein Scannerkopf zur Lasermaterialbearbeitung mit einem Strahllagesystem zum Einstellen der Laserstrahllage beschrieben ist, welches in einer Ausführungsform vier drehbare Spiegel umfasst, die jeweils nur um eine einzige jeweilige Drehachse drehbar ausgebildet sind. Zwei der vier Spiegel sind entlang einer ersten Raumrichtung, ein dritter der vier Spiegel ist entlang einer zweiten Raumrichtung und ein vierter der vier Spiegel entlang einer dritten Raumrichtung ausgerichtet, wobei alle drei Raumrichtungen senkrecht aufeinander stehen. Bei einer alternativen Ausführungsform weist das Strahllagesystem zum Einstellen der Laserstrahllage zwei um jeweils zwei Drehachsen kippbare Doppelachs-Spiegel auf.

In einer Ausführungsform stehen die erste Raumrichtung und die zweite Raumrichtung senkrecht aufeinander. Durch diese senkrechte Anordnung erzielt man für die Einstellung der räumlichen Lage eine Entkopplung zwischen den zwei Spiegelpaaren.

In einer weiteren Ausführungsform folgen die beiden Spiegel des ersten Spiegelpaars im Strahlengang unmittelbar aufeinander. Hierdurch wird die Auflösung für die Einstellung der Position des mindestens einen gepulsten Laserstrahls senkrecht zur ersten Raumrichtung bei gegebener Auflösung der Drehung der Spiegel des ersten Spiegelpaares maximiert.

In einer Weiterbildung dieser Ausführungsform liegt ein Abstand zwischen den beiden Spiegeln des ersten Spiegelpaars bei weniger als 150 mm.

In einer weiteren Ausführungsform folgen die beiden Spiegel des zweiten Spiegelpaars im Strahlengang unmittelbar aufeinander. Hierdurch wird die Auflösung für die Einstellung der Position des mindestens einen gepulsten Laserstrahls senkrecht zur zweiten Raumrichtung bei gegebener Auflösung der Drehung der Spiegel des zweiten Spiegelpaares maximiert.

In einer Weiterbildung dieser Ausführungsform liegt ein Abstand zwischen den beiden Spiegeln des zweiten Spiegelpaars bei weniger als 150 mm.

In einer weiteren Ausführungsform ist der erste Spiegel des zweiten Spiegelpaars im Strahlengang vor dem ersten Spiegelpaar und der zweite Spiegel des zweiten Spiegelpaars im Strahlengang nach dem ersten Spiegelpaar angeordnet. In diesem Fall können der im Strahlengang erste Spiegel, also der erste Spiegel des zweiten Spiegelpaars, und der im Strahlengang zweite Spiegel, bei dem es sich um einen der Spiegel des ersten Spiegelpaares handelt, kleinere Aperturen aufweisen, was eine größere Dynamik im Stellwinkel erlaubt. Der im Strahlengang dritte Spiegel, bei dem es sich um den anderen Spiegel des ersten Spiegelpaares handelt, und der im Strahlengang vierte Spiegel, also der zweite Spiegel des zweiten Spiegelpaars, benötigen größere Aperturen. Durch den größeren Abstand zwischen den beiden Spiegeln des zweiten Spiegelpaars ist für die Verstellung der Position des gepulsten Laserstrahls senkrecht zur zweiten Raumrichtung eine kleinere Drehbewegung der Spiegel notwendig. Hieraus ergibt sich zwar eine geringere Auflösung für die Einstellung der Position des gepulsten Laserstrahls senkrecht zur zweiten Raumrichtung, aber auch eine größere Stelldynamik, was in bestimmten Fällen vorteilhaft sein kann.

Grundsätzlich kann die Ausrichtung der Drehachsen der vier Spiegel auch von den hier beschriebenen Ausrichtungen abweichen. Beispielsweise können die Drehachsen des im Strahlengang ersten und dritten Spiegels entlang einer ersten Raumrichtung und die Drehachsen des im Strahlengang zweiten und vierten Spiegels entlang einer zweiten Raumrichtung ausgerichtet sein, die senkrecht auf der ersten Raumrichtung steht. Abweichende Ausrichtungen erfordern jedoch zum Teil weitere Spiegel, um die Raumrichtung zu korrigieren oder führen zu einer Abhängigkeit zwischen den Stellachsen.

In einer weiteren Ausführungsform weist die Strahllagestelleinrichtung mindestens einen Galvanometerantrieb zur Drehung von jeweils einem der vier Spiegel um seine jeweilige Drehachse auf. Mit Galvanometerantrieben kann eine besonders dynamische Einstellung der räumlichen Lage des gepulsten Laserstrahls, insbesondere eine Einstellung im Frequenzbereich von mehr als 1 kHz, erzielt werden. Auch erlauben Galvanometerantriebe eine hohe Winkelauflösung, also eine hohe Auflösung für die Drehung der Spiegel. Daraus folgt eine hohe Stellauflösung für die räumliche Lage des gepulsten Laserstrahls, insbesondere eine Auflösung der Strahlrichtung entsprechend einem Winkel von weniger als 1 µrad und eine Auflösung der Position entsprechend einem räumlichen Abstand von 1 µm oder weniger.

Anstelle von Galvanometerantrieben können beispielsweise auch geregelte bürstenlose Motoren, gegebenenfalls mit einer Übersetzung zwischen Motor und Spiegel, zur Drehung der Spiegel eingesetzt werden. Auch sogenannte Voicecoilantriebe können zum Einsatz kommen. Letztere weisen allerdings typischerweise einen kleineren Stellbereich auf und ermöglichen keine volle Umdrehung.

In einer weiteren Ausführungsform umfasst die EUV-Lichtquelle mindestens eine Strahllageerfassungseinrichtung zur Erfassung der räumlichen Lage des mindestens einen gepulsten Laserstrahls und mindestens eine Regelungseinrichtung zur Regelung der räumlichen Lage des mindestens einen gepulsten Laserstrahls mittels der mindestens einen Strahllagestelleinrichtung. Die Strahllageerfassungseinrichtung kann beispielsweise mindestens einen positionssensitiven Sensor (z.B. einen Quadranten-Sensor) und/oder mindestens eine positionssensitive Kamera umfassen. Durch Anordnung eines positionssensitiven Sensors bzw. einer positionssensitiven Kamera im Nahfeld des gepulsten Laserstrahls kann die Position, durch Anordnung im Fernfeld kann der Winkel erfasst werden. Mittels der Regelungseinrichtung kann die räumliche Lage des gepulsten Laserstrahls auf einen gewünschten Sollwert eingeregelt werden. Beispielweise kann der Auftreffwinkel des gepulsten Laserstrahls und die Position auf dem Targetmaterial konstant gehalten werden. Die hohe Dynamik ermöglicht die Korrektur von Schwingungen und anderer dynamischer Störprozesse. Dies gilt insbesondere im Fall der Verwendung von Galvanometerantrieben, durch welche die Korrektur höherfrequenter Störungen, die in den eingangs genannten EUV-Lichtquellen regelmäßig auftreten, erst möglich wird. Diese Anforderungen sind mit zweiachsig winkelverstellbaren Spiegeln oder lateral verschiebbaren Linsen nicht zu erfüllen.

In einer weiteren Ausführungsform liegt ein Umlenkwinkel des gepulsten Laserstrahls an mindestens einem der vier Spiegel in einem Winkelbereich zwischen 30° und 90°, bevorzugt zwischen 60° und 90°. Bei der Reflexion eines Laserstrahls an einem Spiegel bezeichnet der Umlenkwinkel den Winkel zwischen dem auftreffenden und dem reflektierten Laserstrahl. Er entspricht dem doppelten Auftreffwinkel ("Angle of Incidence"). Der Umlenkwinkel des gepulsten Laserstrahls an den vier Spiegeln ist grundsätzlich beliebig. Ein Umlenkwinkel kleiner gleich 90° ist jedoch vorteilhaft, um die Abmessungen der Spiegel gering zu halten und um die Effizienz bzw. die Polarisationsabhängigkeit von Beschichtungen der Spiegel zu optimieren.

In einer weiteren Ausführungsform weist eine Vorderseite von mindestens einem der vier Spiegel eine hochreflektierende Beschichtung für den gepulsten Laserstrahl auf. Eine hochreflektierende Beschichtung auf der Vorderseite führt zu weniger Strahlungsverlusten und damit einer höheren Effizienz der EUV-Lichtquelle. Der Reflexionsgrad der beschichteten Vorderseite des Spiegels sollte dazu möglichst hoch liegen, beispielsweise bei mehr als 98 %, bevorzugt bei mehr als 99 %. Bei der hochreflektierenden Beschichtung kann es sich beispielsweise um eine dielektrische Mehrlagenbeschichtung handeln, die bei der Wellenlänge des gepulsten Laserstrahls eine maximale Reflexion aufweist. Das Design einer solchen hochreflektierenden Beschichtung ist dem Fachmann geläufig.

In einer weiteren Ausführungsform weist eine Rückseite von mindestens einem der vier Spiegel eine antireflektierende Beschichtung für den mindestens einen gepulsten Laserstrahl auf. Mittels einer solchen antireflektierenden Beschichtung können unerwünschte Doppelreflexionen vermieden und eine Erwärmung des Spiegels im Betrieb der EUV-Lichtquelle reduziert werden. Bei der antireflektierenden Beschichtung kann es sich ebenfalls um eine dielektrische Mehrlagenbeschichtung handeln, die bei der Wellenlänge des gepulsten Laserstrahls eine minimale Reflexion aufweist.

In einer weiteren Ausführungsform weist ein Substrat von mindestens einem der vier Spiegel für den mindestens einen gepulsten Laserstrahl eine geringe Absorption auf. Bei dem Material kann es sich beispielsweise um ein Silikatglas, insbesondere um Quarzglas ("fused silica"), handeln. Damit wird eine Aufheizung des mindestens einen der vier Spiegel im Betrieb der EUV-Lichtquelle reduziert beziehungsweise vermieden.

In einer weiteren Ausführungsform ist die Strahlführungseinrichtung ausgebildet, den gepulsten Laserstrahl der Strahllagestelleinrichtung kollimiert oder divergent zuzuführen. Die kollimierte Zuführung ist dabei in der Regel zu bevorzugen.

Weitere Merkmale und Vorteile der Erfindung ergeben sich aus der nachfolgenden Beschreibung von Ausführungsbeispielen der Erfindung, anhand der Figuren der Zeichnung, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

### Zeichnung

Ausführungsbeispiele sind in der schematischen Zeichnung dargestellt und werden in der nachfolgenden Beschreibung erläutert. Es zeigen
- Fig. 1: eine schematische Darstellung einer EUV-Lichtquelle mit einer Strahlführungseinrichtung, die eine erste Strahllagestelleinrichtung zur Einstellung der räumlichen Lage eines ersten gepulsten Laserstrahls und eine zweite Strahllagestelleinrichtung zur Einstellung der räumlichen Lage eines zweiten gepulsten Laserstrahls umfasst,
- Fign. 2a,b,c: schematische Detailansichten der ersten Strahllagestelleinrichtung der in der Fig. 1 dargestellten EUV-Lichtquelle, die vier Spiegel in Form zweier Spiegelpaare aufweist, sowie
- Fign. 3a,c,b: schematische Detailansichten einer Variante der in den Fign. 2a,b,c gezeigten Strahllagestelleinrichtung.

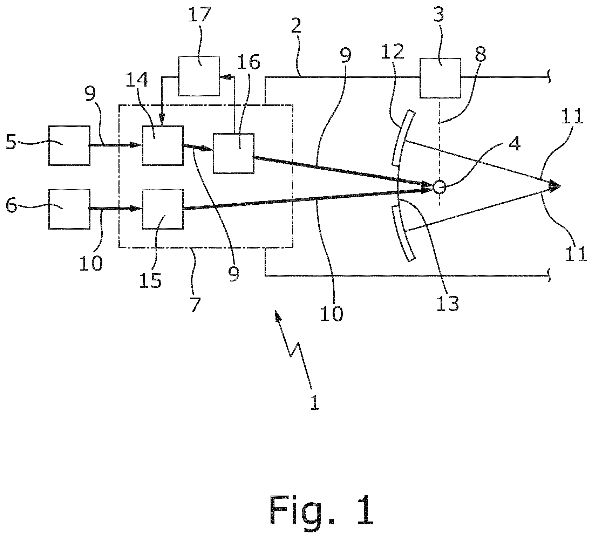

In **Fig. 1** ist eine EUV-Lichtquelle **1** dargestellt, die eine Strahlungserzeugungskammer **2,** eine Bereitstellungseinrichtung **3** zur Bereitstellung eines Targetmaterials **4,** eine erste gepulste Laserquelle **5,** eine zweite gepulste Laserquelle **6** und eine Strahlführungseinrichtung **7** aufweist.

Bei dem Targetmaterial 4 handelt es sich um Zinn, das in Form von Tröpfchen 4 von der Bereitstellungseinrichtung 3 innerhalb der Strahlungserzeugungskammer 2 bereitgestellt wird. Die Tröpfchen 4, die aus der Bereitstellungseinrichtung 3 austreten, bewegen sich innerhalb der Strahlungserzeugungskammer 2 entlang einer vorgegebenen Bewegungsbahn **8,** die näherungsweise geradlinig verläuft. Grundsätzlich kann es sich bei dem Targetmaterial 4 aber auch um ein anderes Material, beispielsweise ein anderes Metall handeln. Auch muss die Bereitstellung mittels der Bereitstellungseinrichtung 3 nicht in Tröpfchenform erfolgen.

Die erste gepulste Laserquelle 5 emittiert einen ersten gepulsten Laserstrahl **9**; die zweite gepulste Laserquelle 6 emittiert einen zweiten gepulsten Laserstrahl **10.** Bei den Laserpulsen des ersten gepulsten Laserstrahls 9 beziehungsweise des zweiten gepulsten Laserstrahls 10 kann es sich beispielsweise um Vorpulse beziehungsweise Hauptpulse handeln. Bei den gepulsten Laserquellen 5,6 handelt es sich hier beispielhaft, aber nicht notwendigerweise, um CO₂-Laser.

Mittels der Strahlführungseinrichtung 7 werden der erste gepulste Laserstrahl 9 und der zweite gepulste Laserstrahl 10 in die Strahlungserzeugungskammer 2 zugeführt. Ferner wird mit der Strahlführungseinrichtung 7 das Targetmaterial 4 mit den gepulsten Laserstrahlen 9,10 fokussiert bestrahlt. Zu diesen Zwecken kann die Strahlführungseinrichtung 7 eine Vielzahl von hier nicht dargestellten transmissiven und/oder reflektiven optischen Elementen aufweisen.

In Folge der Bestrahlung mit einem oder mehreren Laserpulsen des ersten gepulsten Laserstrahls 9 und einem oder mehreren Laserpulsen des zweiten gepulsten Laserstrahls 10 wird das Targetmaterial 4 in den Plasmazustand überführt und es kommt zur Emission von EUV-Strahlung **11,** die mittels eines Kollektorspiegels **12** gesammelt wird, der in der Strahlungserzeugungskammer 2 angeordnet ist. Der Kollektorspiegel 12 weist dabei eine Öffnung **13** auf, durch welche die gepulsten Laserstrahlen 9,10 hindurchtreten.

Ferner weist die Strahlführungseinrichtung 7 eine erste Strahllagestelleinrichtung **14** zur Einstellung der räumlichen Lage des ersten gepulsten Laserstrahls 9 und eine zweite Strahllagestelleinrichtung **15** zur Einstellung der räumlichen Lage des zweiten gepulsten Laserstrahls 10 auf. Die beiden Strahllagestelleinrichtungen 14,15 können identisch oder unterschiedlich aufgebaut sein.

Schließlich umfasst die EUV-Lichtquelle 1 zusätzlich eine Strahllageerfassungseinrichtung **16** zur Erfassung der räumlichen Lage des ersten gepulsten Laserstrahls 9 und eine Regelungseinrichtung **17** zur Regelung der räumlichen Lage des ersten gepulsten Laserstrahls 9 über die erste Strahllagestelleinrichtung 14. Die Strahllageerfassungseinrichtung 16 ist im dargestellten Beispiel Teil der Strahlführungseinrichtung 7. Dies ist aber nicht notwendigerweise der Fall. Die Strahllageerfassungseinrichtung 16 umfasst beispielhaft, aber nicht notwendigerweise zwei hier nicht dargestellte positionssensitive Sensoren, z.B. einen Quadranten-Sensor und/oder mindestens eine positionssensitive Kamera. Bei der Regelungseinrichtung 17 kann es sich um einen herkömmlichen Regler handeln, beispielsweise um einen PID-Regler.

Abweichend von dem dargestellten Beispiel kann die EUV-Lichtquelle auch nur eine gepulste Laserquelle oder mehr als zwei gepulste Laserquellen umfassen. Auch kann das Targetmaterial 4 mit nur einem oder mit mehr als zwei gepulsten Laserstrahlen bestrahlt werden. Ferner kann die Strahlführungseinrichtung 7 auch nur eine oder mehr als zwei Strahllagestelleinrichtungen aufweisen. Beim Einsatz von zwei oder mehr als zwei gepulsten Laserstrahlen kann für alle oder nur für einige oder einen der gepulsten Laserstrahlen eine Strahllagestelleinrichtung vorgesehen sein. Auch kann die räumliche Lage von mehr als einem gepulsten Laserstrahl über eine Strahllagestelleinrichtung eingestellt werden. Die Strahlführungseinrichtung muss auch nicht für jeden der gepulsten Laserstrahlen eine Strahllagestelleinrichtung aufweisen. Schließlich können Strahllageerfassungseinrichtungen und entsprechende Regelungseinrichtungen für alle oder nur für einige oder nur eine der Strahllagestelleinrichtungen vorgesehen sein.

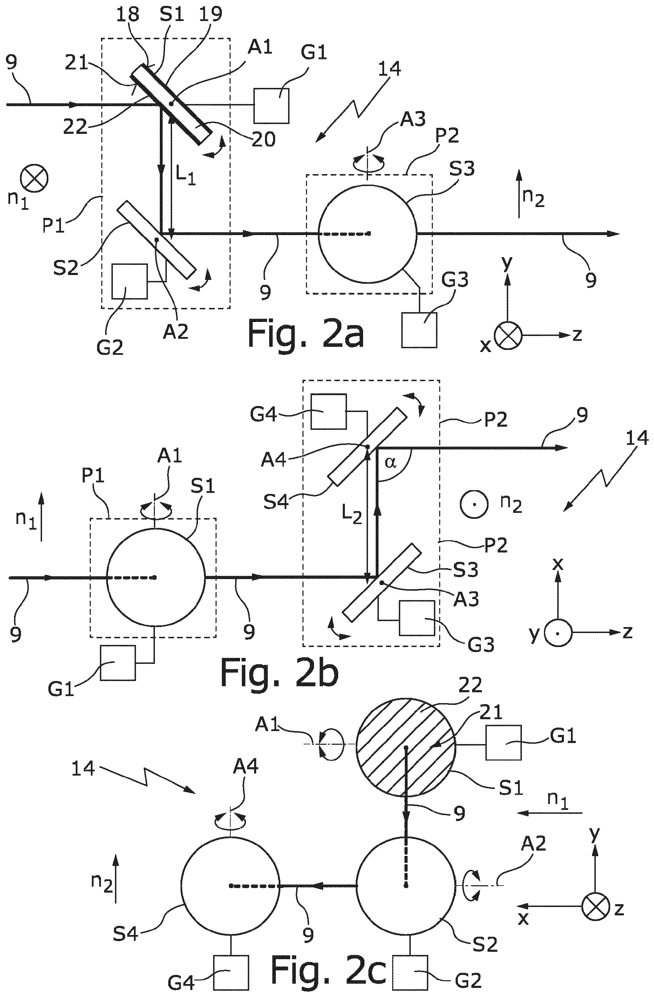

Die **Fign. 2a**,**b**,**c** zeigen schematische Detailansichten der ersten Strahllagestelleinrichtung 14 der in der Fig. 1 dargestellten EUV-Lichtquelle 1, die zur Einstellung der räumlichen Lage des ersten gepulsten Laserstrahls 9 dient und vier Spiegel **S1,S2,S3,S4** in Form zweier Spiegelpaare **P1,P2** umfasst. Die vier Spiegel S1,S2,S3,S4 sind um jeweils genau eine Drehachse **A1,A2,A3,A4** drehbar. Die Drehachsen A1,A2 der beiden Spiegel S1,S2 des ersten Spiegelpaars P1 sind entlang einer ersten Raumrichtung n₁ ausgerichtet. Die Drehachsen A3,A4 der beiden Spiegel S3,S4 des zweiten Spiegelpaars P2 sind entlang einer zweiten Raumrichtung n₂ ausgerichtet. Zur Drehung der vier Spiegel S1,S2,S3,S4 dient für jeden der vier Spiegel S1,S2,S3,S4 jeweils ein Galvanometerantrieb G1,G2,G3,G4. Abweichend davon kann zur Drehung mindestens eines der vier Spiegel S1,S2,S3,S4 auch ein anderer Antrieb eingesetzt werden.

Zur Vereinfachung der Beschreibung ist jeweils ein kartesisches Koordinatensystem mit drei Koordinatenachsen **x,y,z** dargestellt. Die erste Raumrichtung n₁ ist hier parallel zur x-Achse; die zweite Raumrichtung n₂ ist parallel zur y-Achse. Die erste Raumrichtung n₁ und die zweite Raumrichtung n₂ stehen im dargestellten Beispiel also senkrecht aufeinander. Allerdings müssen die erste Raumrichtung n₁ und die zweite Raumrichtung n₂ nicht zwingend senkrecht aufeinander stehen.

In dem in Fign. 2a,b,c dargestellten Beispiel folgen die beiden Spiegel S1,S2 des ersten Spiegelpaars P1 im Strahlengang unmittelbar aufeinander. Außerdem folgen die beiden Spiegel S3,S4 des zweiten Spiegelpaars P2 im Strahlengang unmittelbar aufeinander. Bei dem ersten Spiegel S1 beziehungsweise dem zweiten Spiegel S2 des ersten Spiegelpaars P1 handelt es sich hier um den ersten beziehungsweise zweiten Spiegel im Strahlengang des ersten gepulsten Laserstrahls 9. Bei dem ersten Spiegel S3 beziehungsweise dem zweiten Spiegel S4 des zweiten Spiegelpaars P2 handelt es sich um den dritten beziehungsweise den vierten Spiegel im Strahlengang des ersten gepulsten Laserstrahls 9.

In den Fign. 2a,b,c ist jeweils einer der vier Spiegel S1,S2,S3,S4 durch einen anderen der vier Spiegel S1,S2,S3,S4 verdeckt: In der Fig. 2a ist der zweite Spiegel S4 des zweiten Spiegelpaars P2 vom ersten Spiegel S3 des zweiten Spiegelpaars P2 verdeckt. In der Fig. 2b ist der zweite Spiegel S2 des ersten Spiegelpaars P1 vom ersten Spiegel S1 des ersten Spiegelpaars P1 verdeckt. Schließlich ist in der Fig. 2c der erste Spiegel S3 des zweiten Spiegelpaars P2 vom zweiten Spiegel S2 des ersten Spiegelpaars P1 verdeckt.

Auch der gepulste Laserstrahl 9 ist teilweise verdeckt. Verläuft der gepulste Laserstrahl 9 unmittelbar hinter einem der Spiegel S1,S2,S3,S4, so ist er gestrichelt dargestellt. Die zwei Spiegelpaare P1,P2 sind außerdem lediglich in der Fig. 2a und der Fig. 2b kenntlich gemacht, da sie in der Fig. 2c gezeigten Darstellung teilweise überlappen.

In der Fig. 2a ist außerdem der Abstand L₁ zwischen den beiden Spiegeln S1,S2 des ersten Spiegelpaars P1, in der Fig. 2b der Abstand L2 zwischen den beiden Spiegeln S3,S4 des zweiten Spiegelpaars P2 eingezeichnet. Die Abstände L₁,L₂ betragen im dargestellten Beispiel 100 mm. Allerdings können die Abstände L₁,L₂ auch größer oder kleiner sein und voneinander abweichen. Jedoch liegen die Abstände L₁,L₂ bevorzugt bei weniger als 150 mm.

Wie aus der Fig. 2a hervorgeht, weist die Rückseite **18** des ersten Spiegels S1 des ersten Spiegelpaars P1 eine antireflektierende Beschichtung **19** für den gepulsten Laserstrahl 9 auf. Ferner weist das Substrat **20** des ersten Spiegels S1 des ersten Spiegelpaars P1 für den gepulsten Laserstrahl 9 eine geringe Absorption auf. Bei dem Material des Substrats 20 handelt es sich im gezeigten Beispiel um Quarzglas, es kann sich dabei jedoch auch um ein anderes Material, beispielsweise um SiC handeln, wobei SiC jedoch bei einer Wellenlänge um 1 µm nicht transmissiv ist. Wie ferner aus den Fign. 2a und 2c hervorgeht, weist außerdem die Vorderseite **21** des ersten Spiegels S1 des ersten Spiegelpaars P1 eine reflektierende Beschichtung **22** für den gepulsten Laserstrahl 9 auf. Im gezeigten Beispiel weisen auch die anderen drei Spiegel S2, S3, S4 an ihrer jeweiligen Vorderseite eine reflektierende Beschichtung und an ihrer jeweiligen Rückseite eine antireflektierende Beschichtung für den gepulsten Laserstrahl 9 auf, auf deren Darstellung in Fig. 2a,b,c zur Vereinfachung verzichtet wurde. Im gezeigten Beispiel weist auch bei den anderen drei Spiegeln S2, S3, S4 das Material des jeweiligen Substrats 20 eine geringe Absorption auf.

Im gezeigten Beispiel liegt der Umlenkwinkel **α** des gepulsten Laserstrahls 9 an allen vier Spiegeln S1,S2,S3,S4 bei ca. 90°. Eingezeichnet ist der Umlenkwinkel α hier am zweiten Spiegel S4 des zweiten Spiegelpaars P2 in der Fig. 2b. Der Umlenkwinkel α kann jedoch auch größer oder kleiner als 90° sein. Bevorzugt liegt der Umlenkwinkel α dabei in einem Winkelbereich zwischen 30° und 90°, besonders bevorzugt zwischen 60° und 90°.

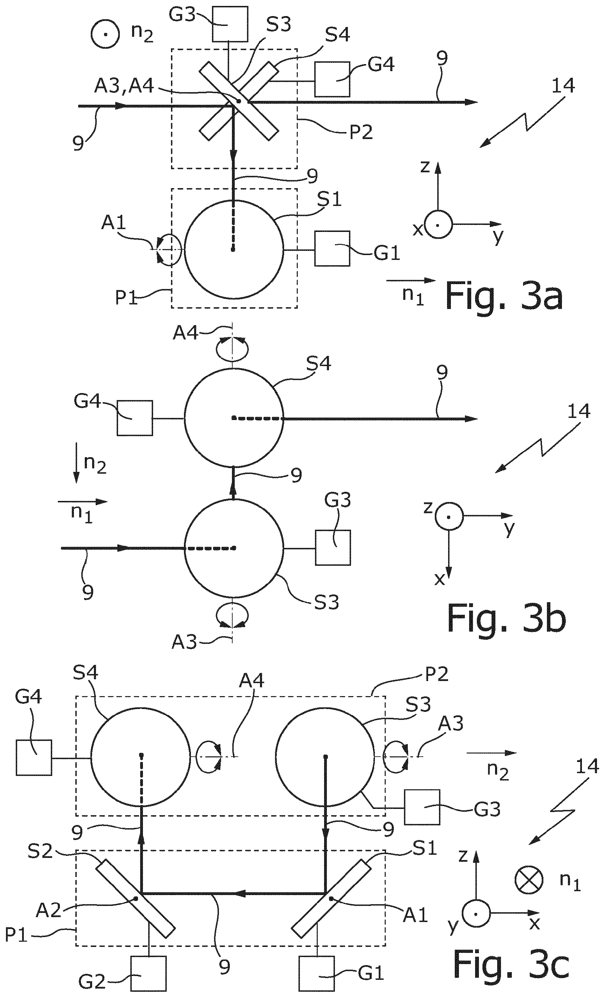

In den Fign. 3a,b,c ist eine alternative Variante der in den Fign. 2a,b,c gezeigten Strahllagestelleinrichtung 14 in drei Detailansichten schematisch dargestellt. Abweichend von den Fign. 2a,b,c ist hier die erste Raumrichtung n₁ parallel zur Propagationsrichtung des in die Strahllagestelleinrichtung 14 eintretenden gepulsten Laserstrahls 9, die der y-Achse entspricht, und die zweite Raumrichtung n₂ parallel zur x-Achse. Ferner ist in den Fign. 3a,b,c der erste Spiegel S3 des zweiten Spiegelpaars P2 im Strahlengang vor dem ersten Spiegelpaar P1 und der zweite Spiegel S4 des zweiten Spiegelpaars P2 im Strahlengang nach dem ersten Spiegelpaar P1 angeordnet.

Bei dem ersten Spiegel S1 beziehungsweise dem zweiten Spiegel S2 des ersten Spiegelpaars P1 handelt es sich hier um den zweiten beziehungsweise dritten Spiegel im Strahlengang des gepulsten Laserstrahls 9. Bei dem ersten Spiegel S3 beziehungsweise dem zweiten Spiegel S4 des zweiten Spiegelpaars P2 handelt es sich um den ersten beziehungsweise vierten Spiegel im Strahlengang des gepulsten Laserstrahls 9.

In der Fig. 3a ist der zweite Spiegel S4 des zweiten Spiegelpaars P2 teilweise vom ersten Spiegel S3 des zweiten Spiegelpaars P2 und der zweite Spiegel S2 des ersten Spiegelpaars P1 vollständig vom ersten Spiegel S1 des ersten Spiegelpaars P1 verdeckt. In der Fig. 3b sind ferner die beiden Spiegel S1,S2 des ersten Spiegelpaars P1 vollständig von den beiden Spiegeln S3,S4 des zweiten Spiegelpaars P2 verdeckt. Die zwei Spiegelpaare P1,P2 sind außerdem lediglich in der Fig. 3a und der Fig. 3c kenntlich gemacht, da sie in der Fig. 3b gezeigten Darstellung überlappen.

## Patentansprüche

1. EUV-Lichtquelle (1), umfassend
- eine Bereitstellungseinrichtung (3) zur Bereitstellung eines Targetmaterials (4),
- mindestens eine gepulste Laserquelle (5,6) zur Emission mindestens eines gepulsten Laserstrahls (9,10),
- eine Strahlführungseinrichtung (7) zur Zuführung des mindestens einen gepulsten Laserstrahls (9,10) von der mindestens einen gepulsten Laserquelle (5,6) in eine Strahlungserzeugungskammer (2) und zur fokussierten Bestrahlung des Targetmaterials (4) mit dem mindestens einen gepulsten Laserstrahl (9,10) innerhalb der Strahlungserzeugungskammer (2),
wobei das Targetmaterial (4) ausgebildet ist, in Folge der Bestrahlung EUV-Strahlung (11) zu emittieren,
wobei die Strahlführungseinrichtung (7) zur Einstellung der räumlichen Lage des mindestens einen gepulsten Laserstrahls (9,10) mindestens eine Strahllagestelleinrichtung (14,15) aufweist, die vier Spiegel (S1,S2,S3,S4) in Form zweier Spiegelpaare (P1,P2) umfasst,
**dadurch gekennzeichnet,**
**dass** die vier Spiegel (S1,S2,S3,S4) um jeweils genau eine Drehachse (A1,A2,A3,A4) drehbar sind und die Drehachsen (A1,A2) der beiden Spiegel (S1,S2) des ersten Spiegelpaars (P1) entlang einer ersten Raumrichtung (n₁) und die Drehachsen (A3,A4) der beiden Spiegel (S3,S4) des zweiten Spiegelpaars (P2) entlang einer zweiten Raumrichtung (n₂) ausgerichtet sind.

2. EUV-Lichtquelle (1) nach Anspruch 1, **dadurch gekennzeichnet, dass** die erste Raumrichtung (n₁) und die zweite Raumrichtung (n₂) senkrecht aufeinander stehen.

3. EUV-Lichtquelle (1) nach Anspruch 1 oder 2, **dadurch gekennzeichnet, dass** die beiden Spiegel (S1,S2) des ersten Spiegelpaars (P1) im Strahlengang unmittelbar aufeinanderfolgen.

4. EUV-Lichtquelle (1) nach Anspruch 3, **dadurch gekennzeichnet, dass** ein Abstand (L₁) zwischen den beiden Spiegeln (S1,S2) des ersten Spiegelpaars (P1) bei weniger als 150 mm cm liegt.

5. EUV-Lichtquelle (1) nach einem der vorhergehenden Ansprüche, **dadurch gekennzeichnet, dass** die beiden Spiegel (S3,S4) des zweiten Spiegelpaars (P2) im Strahlengang unmittelbar aufeinanderfolgen.

6. EUV-Lichtquelle (1) nach Anspruch 5, **dadurch gekennzeichnet, dass** ein Abstand (L₂) zwischen den beiden Spiegeln (S3,S4) des zweiten Spiegelpaars (P2) bei weniger als 150 mm liegt.

7. EUV-Lichtquelle (1) nach Anspruch 3 oder 4, **dadurch gekennzeichnet, dass** der erste Spiegel (S3) des zweiten Spiegelpaars (P2) im Strahlengang vor dem ersten Spiegelpaar (P1) und der zweite Spiegel (S4) des zweiten Spiegelpaars (P2) im Strahlengang nach dem ersten Spiegelpaar (P1) angeordnet ist.

8. EUV-Lichtquelle (1) nach einem der vorhergehenden Ansprüche, **dadurch gekennzeichnet, dass** die Strahllagestelleinrichtung (14,15) mindestens einen Galvanometerantrieb (G1,G2,G3,G4) zur Drehung von jeweils einem der vier Spiegel (S1,S2,S3,S4) um seine jeweilige Drehachse (A1,A2,A3,A4) aufweist.

9. EUV-Lichtquelle (1) nach einem der vorhergehenden Ansprüche, **gekennzeichnet durch**:
- mindestens eine Strahllageerfassungseinrichtung (16) zur Erfassung der räumlichen Lage des mindestens einen gepulsten Laserstrahls (9,10) und
- mindestens eine Regelungseinrichtung (17) zur Regelung der räumlichen Lage des mindestens einen gepulsten Laserstrahls (9,10) mittels der mindestens einen Strahllagestelleinrichtung (14,15).

10. EUV-Lichtquelle (1) nach einem der vorhergehenden Ansprüche, **dadurch gekennzeichnet, dass** ein Umlenkwinkel (α) des gepulsten Laserstrahls (9,10) an mindestens einem der vier Spiegel (S1,S2,S3,S4) in einem Winkelbereich zwischen 30° und 90°, bevorzugt zwischen 60° und 90° liegt.

11. EUV-Lichtquelle (1) nach einem der vorhergehenden Ansprüche, **dadurch gekennzeichnet, dass** eine Vorderseite (21) von mindestens einem der vier Spiegel (S1,S2,S3,S4) eine reflektierende Beschichtung (22) für den gepulsten Laserstrahl (9,10) aufweist.

12. EUV-Lichtquelle (1) nach einem der vorhergehenden Ansprüche, **dadurch gekennzeichnet, dass** eine Rückseite (18) von mindestens einem der vier Spiegel (S1,S2,S3,S4) eine antireflektierende Beschichtung (19) für den mindestens einen gepulsten Laserstrahl (9,10) aufweist.

13. EUV-Lichtquelle (1) nach einem der vorhergehenden Ansprüche, **dadurch gekennzeichnet, dass** ein Substrat (20) von mindestens einem der vier Spiegel (S1,S2,S3,S4) für den mindestens einen gepulsten Laserstrahl (9,10) eine geringe Absorption aufweist.

14. EUV-Lichtquelle (1) nach einem der vorhergehenden Ansprüche, **dadurch gekennzeichnet, dass** die Strahlführungseinrichtung (7) ausgebildet ist, den gepulsten Laserstrahl (9,10) der Strahllagestelleinrichtung (14,15) kollimiert oder divergent zuzuführen.

## Claims

1. An EUV light source (1), comprising
- a provisioning device (3) for providing a target material (4),
- at least one pulsed laser source (5, 6) for the emission of at least one pulsed laser beam (9, 10),
- a beam guiding device (7) for feeding the at least one pulsed laser beam (9, 10) from the at least one pulsed laser source (5, 6) to a radiation generation chamber (2), and for irradiating the target material (4) with the at least one pulsed laser beam (9, 10) in a focused manner inside of the radiation generation chamber (2), wherein the target material (4) is designed to emit EUV radiation (11) following the irradiation,
wherein the beam guiding device (7) has at least one beam position adjusting device (14, 15) for adjusting the spatial position of the at least one pulsed laser beam (9, 10), the adjusting device comprising four mirrors (S1, S2, S3, S4) in the form of two pairs of mirrors (P1, P2),
**characterized in that** each of the four mirrors (S1, S2, S3, S4) is rotatable about precisely one axis of rotation (A1, A2, A3, A4), respectively, and that the axes of rotation (A1, A2) of the two mirrors (S1, S2) of the first pair of mirrors (P1) are aligned along a first spatial direction (n₁) and the axes of rotation (A3, A4) of the two mirrors (S3, S4) of the second pair of mirrors (P2) are aligned along a second spatial direction (n₂).

2. The EUV light source (1) according to claim 1, **characterized in that** the first spatial direction (n₁) and the second spatial direction (n₂) are perpendicular to one another.

3. The EUV light source (1) according to claim 1 or 2, **characterized in that** the two mirrors (S1, S2) of the first pair of mirrors (P1) follow directly one after the other in the beam path.

4. The EUV light source (1) according to claim 3, **characterized in that** a distance (L₁) between the two mirrors (S1, S2) of the first pair of mirrors (P1) is less than 150 mm cm.

5. The EUV light source (1) according to one of the preceding claims, **characterized in that** the two mirrors (S3, S4) of the second pair of mirrors (P2) follow directly one after the other in the beam path.

6. The EUV light source (1) according to claim 5, **characterized in that** a distance (L₂) between the two mirrors (S3, S4) of the second pair of mirrors (P2) is less than 150 mm.

7. The EUV light source (1) according to claim 3 or 4, **characterized in that** the first mirror (S3) of the second pair of mirrors (P2) is arranged prior to the first pair of mirrors (P1) in the beam path and the second mirror (S4) of the second pair of mirrors (P2) is arranged after the first pair of mirrors (P1) in the beam path.

8. The EUV light source (1) according to one of the preceding claims, **characterized in that** the beam position adjusting device (14, 15) has at least one galvanometer drive (G1, G2, G3, G4) for rotating one of the four mirrors (S1, S2, S3, S4), in each case, about its respective axis of rotation (A1, A2, A3, A4).

9. The EUV light source (1) according to one of the preceding claims, **characterized by**:
- at least one beam position detection device (16) for detecting the spatial position of the at least one pulsed laser beam (9, 10) and
- at least one feedback control device (17) for feedback controlling the spatial position of the at least one pulsed laser beam (9, 10) by means of the at least one beam position adjusting device (14, 15).

10. The EUV light source (1) according to one of the preceding claims, **characterized in that** a redirection angle (α) of the pulsed laser beam (9, 10) on at least one of the four mirrors (S1, S2, S3, S4) lies within an angular range of between 30° and 90°, preferably between 60° and 90°.

11. The EUV light source (1) according to one of the preceding claims, **characterized in that** a front side (21) of at least one of the four mirrors (S1, S2, S3, S4) has a reflecting coating (22) for the pulsed laser beam (9, 10).

12. The EUV light source (1) according to one of the preceding claims, **characterized in that** a rear side (18) of at least one of the four mirrors (S1, S2, S3, S4) has an anti-reflecting coating (19) for the at least one pulsed laser beam (9, 10).

13. The EUV light source (1) according to one of the preceding claims, **characterized in that** a substrate (20) of at least one of the four mirrors (S1, S2, S3, S4) has a low absorption for the at least one pulsed laser beam (9, 10).

14. The EUV light source (1) according to one of the preceding claims, **characterized in that** the beam guiding device (7) is designed to feed the pulsed laser beam (9, 10) to the beam position adjusting device (14, 15) in a collimated or divergent form.

## Revendications

1. Source de lumière EUV (1), comprenant
- un dispositif de mise à disposition (3) destiné à mettre à disposition un matériau cible (4),
- au moins une source laser pulsée (5, 6) destinée à émettre au moins un faisceau laser pulsé (9, 10),
- un dispositif de guidage de faisceau (7) destiné à amener ledit au moins un faisceau laser pulsé (9, 10) depuis ladite au moins une source laser pulsée (5, 6) vers une chambre de génération de rayonnement (2) et à irradier de manière focalisée le matériau cible (4) avec ledit au moins un faisceau laser pulsé (9, 10) à l'intérieur de la chambre de génération de rayonnement (2),
dans laquelle le matériau cible (4) est conçu pour émettre un rayonnement EUV (11) en réponse à l'irradiation,
dans laquelle le dispositif de guidage de faisceau (7), afin d'ajuster la position spatiale dudit au moins un faisceau laser pulsé (9, 10), présente au moins un dispositif de réglage de la position du faisceau (14, 15), qui comprend quatre miroirs (S1, S2, S3, S4) sous la forme de deux paires de miroirs (P1, P2), **caractérisée en ce que** les quatre miroirs (S1, S2, S3, S4) peuvent tourner respectivement autour d'un seul axe de rotation (A1, A2, A3, A4), et que les axes de rotation (A1, A2) des deux miroirs (S1, S2) de la première paire de miroirs (P1) sont orientés selon une première direction spatiale (n₁), et que les axes de rotation (A3, A4) des deux miroirs (S3, S4) de la deuxième paire de miroirs (P2) sont orientés selon une deuxième direction spatiale (n₂).

2. Source de lumière EUV (1) selon la revendication 1, **caractérisée en ce que** la première direction spatiale (n₁) et la deuxième direction spatiale (n₂) sont perpendiculaires l'une à l'autre.

3. Source de lumière EUV (1) selon la revendication 1 ou 2, **caractérisée en ce que** les deux miroirs (S1, S2) de la première paire de miroirs (P1) se suivent immédiatement dans le trajet du faisceau.

4. Source de lumière EUV (1) selon la revendication 3, **caractérisée en ce qu'**une distance (L₁) entre les deux miroirs (S1, S2) de la première paire de miroirs (P1) est inférieure à 150 mm cm.

5. Source de lumière EUV (1) selon l'une des revendications précédentes, **caractérisée en ce que** les deux miroirs (S3, S4) de la deuxième paire de miroirs (P2) se suivent immédiatement dans le trajet du faisceau.

6. Source de lumière EUV (1) selon la revendication 5, **caractérisée en ce qu'**une distance (L₂) entre les deux miroirs (S3, S4) de la deuxième paire de miroirs (P2) est inférieure à 150 mm.

7. Source de lumière EUV (1) selon la revendication 3 ou 4, **caractérisée en ce que** le premier miroir (S3) de la deuxième paire de miroirs (P2) est disposé dans le trajet du faisceau en amont de la première paire de miroirs (P1), et **en ce que** le deuxième miroir (S4) de la deuxième paire de miroirs (P2) est disposé dans le trajet du faisceau en aval de la première paire de miroirs (P1).

8. Source de lumière EUV (1) selon l'une des revendications précédentes, **caractérisée en ce que** le dispositif de réglage de la position du faisceau (14, 15) présente au moins un entraînement galvanométrique (G1, G2, G3, G4) permettant de faire pivoter respectivement un des quatre miroirs (S1, S2, S3, S4) autour de son axe de rotation (A1, A2, A3, A4) respectif.

9. Source de lumière EUV (1) selon l'une des revendications précédentes, **caractérisée par** :
- au moins un dispositif de détection de la position du faisceau (16) permettant de détecter la position spatiale dudit au moins un faisceau laser pulsé (9, 10), et
- au moins un dispositif de régulation (17) destiné à réguler la position spatiale dudit au moins un faisceau laser pulsé (9, 10) au moyen dudit au moins un dispositif de réglage de la position du faisceau (14, 15).

10. Source de lumière EUV (1) selon l'une des revendications précédentes, **caractérisée en ce qu'**un angle de déviation (α) du faisceau laser pulsé (9, 10) sur au moins l'un des quatre miroirs (S1, S2, S3, S4) est compris dans une plage angulaire allant de 30° à 90°, de préférence entre 60° et 90°.

11. Source de lumière EUV (1) selon l'une des revendications précédentes, **caractérisée en ce qu'**une face avant (21) d'au moins l'un des quatre miroirs (S1, S2, S3, S4) présente un revêtement réfléchissant (22) pour le faisceau laser pulsé (9, 10).

12. Source de lumière EUV (1) selon l'une des revendications précédentes, **caractérisée en ce qu'**une face arrière (18) d'au moins l'un des quatre miroirs (S1, S2, S3, S4) présente un revêtement antireflet (19) pour ledit au moins un faisceau laser pulsé (9, 10).

13. Source de lumière EUV (1) selon l'une des revendications précédentes, **caractérisée en ce qu'**un substrat (20) d'au moins l'un des quatre miroirs (S1, S2, S3, S4) présente une faible absorption pour ledit au moins un faisceau laser pulsé (9, 10).

14. Source de lumière EUV (1) selon l'une des revendications précédentes, **caractérisée en ce que** le dispositif de guidage de faisceau (7) est conçu pour amener le faisceau laser pulsé (9, 10) au dispositif de réglage de la position du faisceau (14, 15) de manière collimatée ou divergente.
